# EUROPEAN PATENT SPECIFICATION

(11) **EP 0 499 241 B1**
(45) Date of publication and mention of the grant of the patent: **05.06.1996**
(21) Application number: 92102354.5
(22) Date of filing: 12.02.1992
(51) Int. Cl.: H01L 21/3205, H01L 21/285

(54) **Sputtering process for forming aluminum layer over stepped semiconductor wafer**
Sputterverfahren zum Bilden einer Aluminiumschicht auf einem gestuften Wafer
Procédé de pulvérisation d'une couche d'aluminium sur des plaquettes échelonnées

(30) Priority: 12.02.1991 US 658140
(43) Date of publication of application: 19.08.1992
(73) Proprietor: APPLIED MATERIALS, INC., Santa Clara California 95054-3299 (US)
(72) Inventor: Wang, Chien-Rhone, Milpitas, CA 95035 (US); Gilboa, Haim, Palo Alto, CA 94306 (US)
(74) Representative: DIEHL GLAESER HILTL & PARTNER

(56) References cited:
- EP-A- 0 273 715
- THIN SOLID FILMS. vol. 153, no. 1, October 1987, LAUSANNE CH pages 369 - 377; V. HOFFMAN ET.AL.: 'PLANARISATION OF ALUMINIUM ALLOY FILM DURING HIGH RATE SPUTTERING'

## Description

This invention relates to a sputtering process for forming a layer of aluminum on a semiconductor wafer.

In the formation of an aluminum layer by sputtering to deposit aluminum over a stepped surface, e.g., where the integrated circuit structure includes spaced lines, trenches, and/or vias or contact holes on a semiconductor wafer, where the spacing is small, e.g., the spaced lines or trench walls are less than 1.6 µm (microns) apart or the via diameters are less than 1.6µm, aluminum layers formed by conventional sputtering processes not only are not planar, but such aluminum layers actually are thinner in the regions between such closely spaced apart raised portions, i.e., between steps or trench walls or over the vias.

This is thought to be due to a shadowing effect wherein the raised portions or steps on either side of the narrow regions prevent or inhibit deposition of the sputtered atoms from reaching such regions unless the atom reaches the wafer from a path which is nearly perpendicular to the wafer. That is, sputtered atoms traveling at an angle toward the wafer encounter the raised steps, or sidewalls of the trench or via, and deposit thereon without reaching the low regions on the wafer between such closely or narrowly spaced apart raised portions.

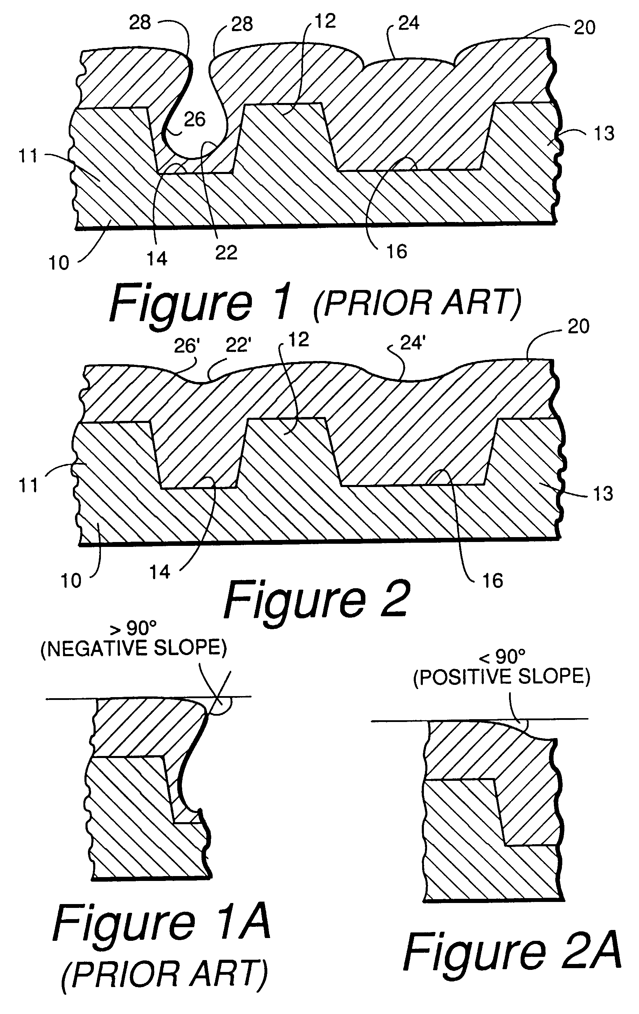

Figure 1, which is illustrative of the results obtained using such prior art processes, shows the effects of shadowing when steps on a semiconductor wafer are closely spaced apart. A semiconductor wafer 10 is shown having steps 11, 12, and 13 formed on the wafer prior to the sputtering of an aluminum layer 20 thereon. Aluminum layer 20 does not fill narrow region 14 between closely spaced apart steps 11 and 12, but rather only forms a thin layer portion 22 which is thinner than the remainder of aluminum layer 20, because region 14 is shadowed by the adjacent high steps 11 and 12. In contrast, the wider region 16 between steps 12 and 13, which are not closely spaced apart, is completely filled with aluminum which, as seen at 24, is not thinner than the remainder of layer 20, presumably because there is no shadowing effect here as there is in region 14.

In addition to the difference in thickness between the aluminum deposited in regions 14 and 16, it will be noted that aluminum layer 20 forms a thin layer at 26 on the sidewalls of narrow region 14 and that aluminum layer 20 then gradually slopes inwardly, in what made be termed a "negative" slope, to define an overhang or inward necking of aluminum layer 20 at 28 in prior art Figure 1. While this effect will also be noted slightly in aluminum layer 20 at 24 over region 16 in Figure 1, the effect over such wide regions is negligible. However, this negative slope effect in regions between closely spaced apart raised portions of a semiconductor wafer, such as shown over region 14 in Figure 1, can result in the formation of voids in the aluminum layer as well as add to the shadowing effect by further hindering the passage of sputtered aluminum into region 14.

Since integrated circuit structures formed on semiconductor wafers are becoming smaller and smaller with finer features, including thinner lines, smaller line pitches, and smaller contact holes, it is important to be able to overcome this shadowing effect and negative slope deposition of aluminum in low areas between closely spaced apart raised portions of a semiconductor wafer; and to be able to sputter an aluminum layer on a wafer surface containing closely spaced apart raised portions, which will not form such thin films or layers in the regions between the closely spaced apart raised portions of the integrated circuit structure, but will rather substantially completely fill in such low areas between closely spaced apart raised portions of a semiconductor wafer and which will not form negative slopes during the aluminum deposition.

Prior art approaches to the formation of aluminum layers over such integrated circuit structures usually comprise a combination of a sputtering deposition process and a biasing of the wafer, either during or after the deposition step or steps, to provide ion bombardment of the wafer to cause the deposited aluminum to fill in such low regions. For example, Lamont Jr., et al. U.S. Patent 4,756,810 describes a method and apparatus for sputtering an aluminum layer on a substrate over an integrated circuit structure containing vias to be filled by the deposited aluminum layer wherein a bias voltage is applied to the substrate at an RF frequency of from about 5 kHz to about 1 MHz, whereby ions from the plasma bombard the substrate to redistribute aluminum already deposited to assist in planarizing the aluminum layer and filling the vias.

Inoue U.S. Patent 4,810,342 discloses a method of sputtering wiring material such as aluminum lines onto a semiconductor wafer wherein the temperature of the wafer is maintained by using a first source of heated gas and then decreasing the flow of this heated gas as the wafer temperature rises and simultaneously increasing the flow of the same gas from a second source so that both the temperature and the pressure remain constant.

Kamoshida et al. U.S. Patent 4,816,126 describes a method of planarizing an aluminum film on a substrate by bombarding the film with charged particles accelerated by a bias voltage of greater than 850 volts to fluidize the film by the temperature rise. In one embodiment, the aluminum film is first formed on the substrate and then fluidized by application of a bias voltage to the substrate, which causes ions such as argon ions in the resulting plasma to impinge on the aluminum film. In another embodiment, the substrate is biased during the sputter deposition. The aluminum is gradually fluidized by the temperature rise in the substrate and the bombardment of the substrate with charged particles as a result of the bias on the substrate. In a third embodiment, a first film of aluminum is deposited without bias, i.e., without ion bombardment, and a second layer of aluminum is deposited while bias voltage is applied, i.e., while bombarding the substrate with ions to fluidize the film.

In European Patent Application EPA 0451571, cross-reference to which is hereby made, aluminum is deposited on a semiconductor wafer in a three stage process wherein bias is applied to the wafer during the second and third steps and the wafer temperature is controlled only during the third deposition step.

Now, it has been found that a planar aluminum layer can may be deposited on a semiconductor wafer in a multistep process which will fill in low areas between closely spaced apart raised portions on the wafer without biasing the wafer during any of the deposition steps, i.e., without bombarding the wafer with ions from the plasma during the deposition of the aluminum layer.

It is, therefore, an object of this invention to provide an improved process for sputtering an aluminum layer on a semiconductor wafer having closely spaced apart raised portions which will substantially completely fill in low areas between such closely spaced apart raised portions on the wafer, without biasing the wafer during the sputter deposition process, and which will not form negative slopes during the aluminum deposition. This object is solved by the process of independent claim 1.

The multi-step sputtering process herein described is applicable for depositing a layer of aluminum over a surface on a semiconductor wafer having closely spaced apart raised portions without biasing the wafer.

The improved process herein described is also applicable for sputtering an aluminum layer on a semiconductor wafer having closely spaced apart raised portions using a multistep process wherein the wafer temperature prior to the deposition process preferably does not exceed about 100°C. An aluminum layer not exceeding about 300 NM (3000 Angstroms) is sputtered onto a wafer in a first step while maintaining the wafer at a temperature less than about 150°C and a target power level sufficient to provide a deposition rate of from about 20 to about 30 NM/second (200 to about 300 Angstroms/second) for a period of from about 0.1 to about 0.3 minutes; then, in a second sputtering step, the target power level range is lowered sufficiently to provide a deposition rate of from about 2 to about 4 NM/second (20 to about 40 Angstroms/second) for a period of from about 0.2 to about 1.1 minutes, and the wafer temperature is allowed to rise to a temperature not exceeding about 600°C; and a third sputter deposition step is carried out by raising the target power level sufficiently to provide a deposition rate of from about 10 to about 25 NM (100 to about 250 Angstroms) per second, while maintaining the wafer temperature at a temperature not exceeding about 600°C, until a final thickness of from about 0.6 to about 2 µm is reached, whereby low areas between closely spaced apart raised portions on the wafer will be substantially completely filled in and negative slopes will not be formed, without applying a bias voltage to the wafer.

The improved process herein described is also applicable for sputtering an aluminum layer on a semiconductor wafer having closely spaced apart raised portions using a multistep process, without applying a bias voltage to the wafer, wherein an aluminum layer not exceeding about 300 NM (3000 Angstroms) is sputtered onto a wafer in a first step while maintaining the wafer at a temperature less than about 150°C and a target power level sufficient to provide a deposition rate of from about 20 to about 30 NM/second (200 to about 300 Angstroms/second) for a period of from about 0.1 to about 0.3 minutes; then, in a second sputtering step, the target power level range is lowered sufficiently to provide a deposition rate of from about 2 to about 4 NM/second (20 to about 40 Angstroms/second) for a period of from about 0.6 to about 1.1 minutes, and the wafer temperature is allowed to rise to a temperature of from about 475°C to about 600°C; and a third sputter deposition step is carried out by raising the target power level sufficiently to provide a deposition rate of from about 10 to about 25 NM/second (100 to about 250 Angstroms/second), while maintaining the wafer at a temperature of from about 475°C to about 600°C, until a final thickness of from about 1 to about 2 µm is reached, whereby low areas between closely spaced apart raised portions on the wafer will be substantially completely filled in and negative slopes will not be formed, without applying a bias voltage to the wafer.

The improved process herein described is also applicable for sputtering an aluminum layer on a on a semiconductor wafer having closely spaced apart raised portions using a multistep process, without applying a bias voltage to the wafer, which comprises providing a wafer at a temperature of less than about 150°C in a vacuum apparatus; moving the wafer to a sputtering zone in the vacuum apparatus; sputtering an aluminum layer of from about 100 to about 300 NM (1000 to about 3000 Angstroms) onto a wafer in a first step, while maintaining the wafer at a temperature less than about 150°C and a target power level sufficient to provide a deposition rate of from about 20 to about 30 NM (200 to about 300 Angstroms) per second for a period of from about 0.1 to about 0.3 minutes; then, in a second sputtering step, lowering the target power level range sufficiently to provide a deposition rate of from about 2 to about 4 NM (20 to about 40 Angstroms) per second for a period from about 0.6 to about 1.1 minutes, while raising the wafer temperature to a temperature of from about 500°C to about 600°C by moving a wafer support containing a heater into contact with portions of the backside of the wafer and contacting this backside of the wafer with a thermally conductive gas to thermally couple the wafer to the wafer support to stabilize the temperature of the wafer. The wafer support platform and heater can be heated prior to said first deposition step. A third sputter deposition step is carried out by raising the target power level sufficiently to provide a deposition rate of from about 10 to about 25 NM/second (100 to about 250 Angstroms/second), while maintaining the wafer at temperature of from about 500°C to about 600°C, until a final thickness of from about 0.6 to about 2 micrometers is reached, whereby low areas between closely spaced apart raised portions on the wafer will be substantially completely filled in and negative slopes will not be formed, without applying a bias voltage to the wafer.

The apparatus herein described is also applicable for sputtering an aluminum layer on a semiconductor wafer having closely spaced apart raised portions, without applying a bias voltage to the wafer, which means for cooling a wafer to a temperature of less than about 150°C in a vacuum apparatus; means for moving the wafer to a sputtering zone in the vacuum apparatus; means for sputtering an aluminum layer of from about 100 to about 300 NM (1000 to about 3000 Angstroms) onto the wafer in a first step, while maintaining the wafer at a temperature less than about 150°C and a target power level sufficient to provide a deposition rate of from about 20 to about 30 NM (200 to about 300 Angstroms) per second for a period of from about 0.1 to about 0.2 minutes; means for raising the wafer temperature to a temperature of from about 500°C to about 600°C comprising means for moving a wafer support containing a heater into contact with portions of the backside of the wafer and means for contacting this backside of the wafer with a thermally conductive gas to thermally couple the wafer to the wafer support to heat and stabilize the temperature of the wafer during this second sputtering step, while providing a target power level range sufficient to provide a deposition rate of from about 2 to about 4 NM (20 to about 40 Angstroms) per second for a period of from about 0.6 to about 1.1 minutes; and means for raising the target power level sufficiently to provide a deposition rate of from about 10 to about 25 NM/second (100 to about 250 Angstroms/second) in a third deposition step, while maintaining the wafer at a temperature of from about 500°C to about 600°C, until a final thickness of from about 0.6 to about 2 micrometers is reached, whereby low areas between closely spaced apart raised portions on the wafer will be substantially completely filled in and negative slopes will not be formed, without applying a bias voltage to the wafer.

These and other details of the invention will be apparent from the following description and accompanying drawings.

Figure 1 is a fragmentary vertical cross-sectional view of an aluminum layer sputtered by a prior art process onto a semiconductor wafer having closely spaced apart steps thereon.

Figure 1A is a fragmentary vertical cross-sectional view of a portion of Figure 1, with numerals omitted for clarity, showing the greater than 90° angle which the aluminum layer in the low region 14 of Figure 1 defines with the remainder of the aluminum layer, referred to as a "negative slope".

Figure 2 is a fragmentary vertical cross-sectional view of an aluminum layer sputtered by the process of the invention onto a semiconductor wafer having closely spaced apart steps thereon.

Figure 2A is a fragmentary vertical cross-sectional view of a portion of Figure 2, with numerals omitted for clarity, showing the less than 90° angle which the aluminum layer in the low region 14 of Figure 2 defines with the remainder of the aluminum layer, referred to as a "positive slope".

Figure 3 is a vertical cross-sectional view of a sputtering chamber used in the process of the invention, showing the wafer just after loading it into the chamber and prior to raising it to the sputtering position.

Figure 4 is a vertical cross-sectional view of sputtering chamber of Figure 3, but showing the wafer raised to the sputtering position for the first sputtering step, when a single chamber is used for the entire sputtering process.

Figure 5 is a vertical cross-sectional view of the same sputtering chamber shown in Figures 3 and 4, but with the wafer support and heater platform raised to a position in contact with the backside of the wafer to control the wafer temperature.

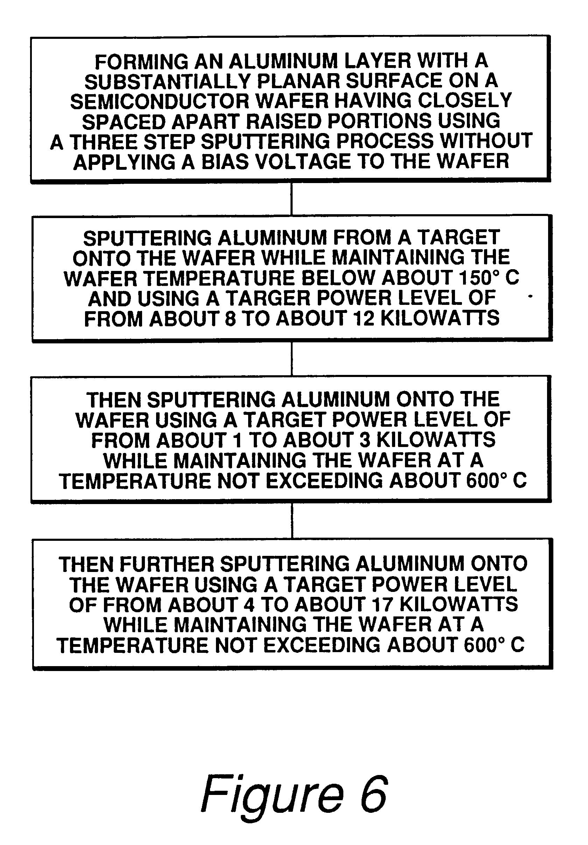

Figure 6 is a flow sheet illustrating the process of the invention.

In accordance with the invention, an aluminum layer is sputtered onto the surface of a semiconductor wafer using a multistep process whereby, as shown at 22' in Figure 2, regions between closely spaced apart steps on the wafer are substantially completely filled in, in contrast to the results of the prior art process shown in Figure 1. Furthermore, deposition of the aluminum layer will not result in a surface having a negative slope, such as shown at 26 in Figure 1, but rather the aluminum will deposit to form a layer ranging from a substantially planar layer to a positive slope such as shown at 24' and 26' in Figure 2.

By use of the term "closely spaced apart raised portions" herein is meant raised portions on a semiconductor wafer, such as raised lines, or the opposite walls of a trench, or the sidewalls of a via, wherein the aspect ratio between the height of such raised portions (or walls) over the width of the low areas therebetween ranges from about 0.625 (1/1.6) to at least about 0.83, and in some instances as high as 1.2 when the walls are tapered to about 80° or less with respect to the surface of the wafer.

The terms "negative slope" and "positive slope" as used herein in describing the surface of the aluminum layer sputtered on a semiconductor wafer in accordance with the invention, refers to the angle which the surface of the aluminum layer over a low region of the semiconductor wafer between closely spaced apart raised portions of the wafer defines with respect to the remainder of the surface of the aluminum layer. When the angle is over 90°, as shown at 26 in Figure 1 and in Figure 1A, the slope is referred to as a "negative slope", while an angle of less than 90°, as shown in Figures 2 and 2A, will be referred to as a "positive slope".

With regard to not applying a biasing voltage to the wafer so that the wafer is not bombarded during the sputtering process, the use of expressions such as "...without applying a bias voltage to the wafer..." are intended to mean that a biasing voltage is not applied to the wafer either while aluminum is being sputtered from the target, i.e., during the deposition; or after the actual sputtering is stopped, i.e., after power to the target has been shut off, such as is described in the aforementioned Kamoshida et al. patent.

The sputtered aluminum layer formed by the process of the invention may be pure aluminum, e.g., 99.9+ wt.% aluminum, or it may comprise an aluminum alloy containing up to about 2 wt.% silicon or up to about 4 wt.% copper or a mixture of both within these specified limits. It will, therefore, be understood that the use of the term "aluminum" herein is intended to include both pure aluminum and aluminum alloyed with either silicon or copper or both within the limits described.

It should also be noted that the multiple step sputtering process of the invention may be carried out either in the same chamber or in more than one chamber. The use of a single chamber for all of the deposition steps is preferred to avoid contaminating the wafer during movement of the wafer from one chamber to another. For example, contamination such as oxidation (to form aluminum oxide) may be inhibited when using a single chamber by actually continuing to deposit aluminum on the wafer as the deposition parameters are changed from one step to another. In contrast, as will be discussed in more detail below, a high vacuum would need to be used during the transfer to avoid the occurrence of contamination during such interruption of the deposition process. For this reason, the apparatus, and in particular, the process steps, of the invention will first be discussed with respect to a multiple step deposition which is carried out in the same deposition chamber of a vacuum apparatus.

### a) Sputtering Apparatus

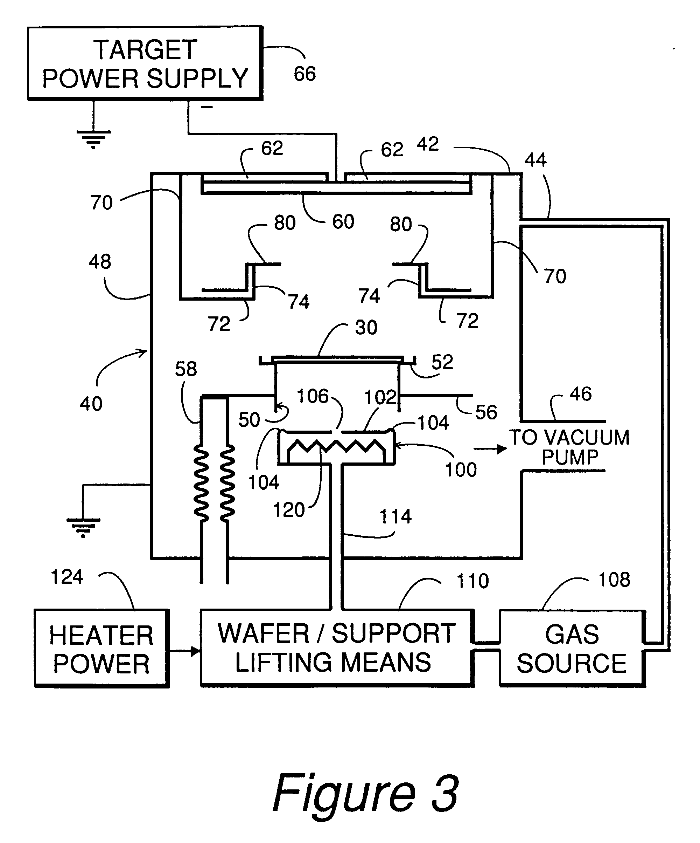

Typical sputtering apparatus which may be used to carry out the process of the invention is shown in Figures 3-5. A wafer 30 is initially inserted into a sputtering chamber 40 comprising top wall 42 and sidewalls 48 and placed on a wafer support member such as the cylindrical or ring shaped support member 50 shown in Figures 3-5, which is provided with an enlarged upper flange 52 of suitable diameter to provide a support for wafer 30. Support member 50 may be positioned or supported in chamber 40 by a collar 56 which is, in turn, mounted on an expandable bellows member 58 which permits support member 50, and wafer 30 thereon, to be raised to a sputtering position in chamber 40.

Chamber 40 is further provided with a sputtering gas inlet port 44 connected to a source of a sputtering gas 108 such as argon (not shown) which is flowed into chamber 40 at a rate of from about 15 standard cubic centimeters/minute (sccm) to about 300 sccm. The same source of sputtering gas is also used to provide gas to the backside of the wafer through opening 106 as will be described below. An outlet port 46 in chamber 40 is connected to a vacuum pump means (not shown) to maintain a pressure within sputtering chamber 40 within a range of from about 1.3 * 10⁻⁶bar to about 10.4 *10⁻⁶bar (1 to about 8 millitorr).

Mounted to top wall 42 of chamber 40 is an aluminum target 60 which is insulated from the grounded walls 48 of chamber 40 by insulators 62. Target 60 is electrically connected to the negative terminal of a power supply 66 having an adjustable (resetable) power level.

Surrounding target 60 and mounted to top wall 42 of chamber 40 is a cylindrical shield member 70 which is provided with a lower flange or shoulder 72 and an upwardly extending inner lip 74 which carries a clamping ring 80 to engage the edges of the top surface of wafer 30, when the wafer is raised to the sputtering position, to seal wafer 30 to a circular wafer support and heating platform 100 for a purpose which will be explained below.

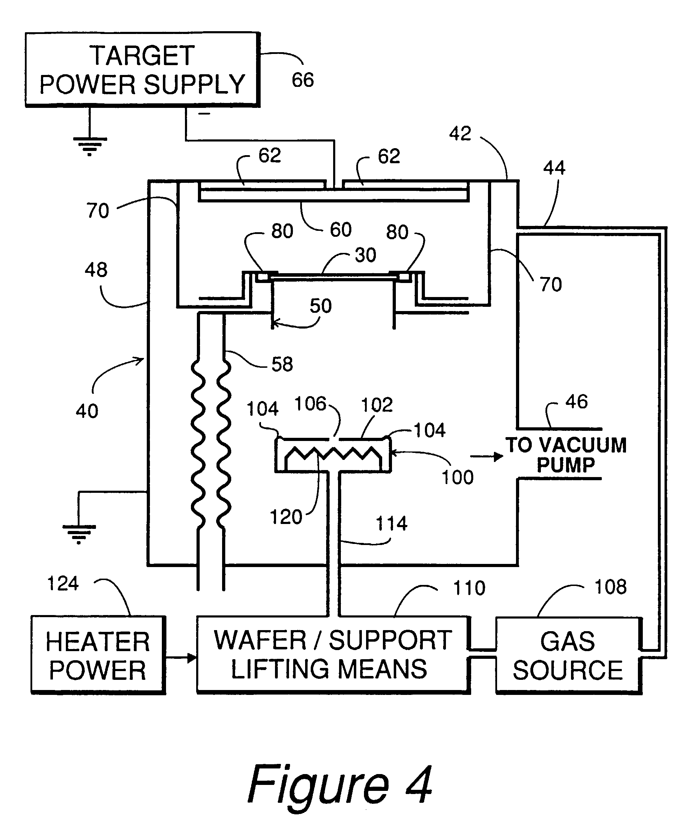

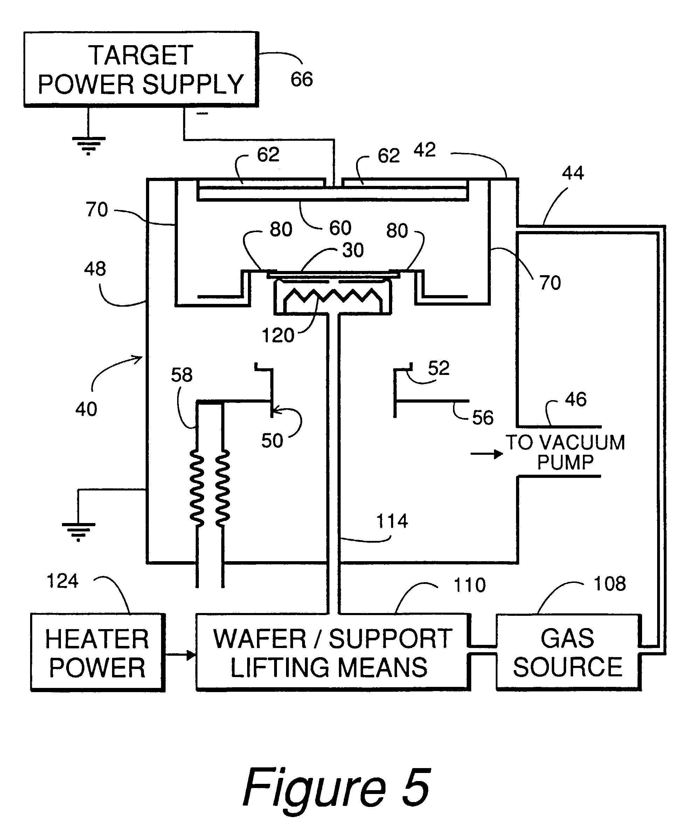

Wafer support and heating platform 100 and wafer support ring 50 are both shown in Figures 3 in a position below wafer 30 to facilitate initial loading of wafer 30 into chamber 10. Heating platform 100 and support ring 50 are each independently capable of being raised to support wafer 30 in a deposition position below target 60 as respectively shown in Figures 4 and 5.

As shown in Figures 4, expandable bellows member 58 is expandable, via an external fluid power means (not shown), to lift wafer support 50 and wafer 30 thereon into a sputtering position within shield 70 and beneath target 60 to permit the sputter deposition of an aluminum layer on wafer 30 in a first deposition step before the wafer is further heated or subject to temperature control by contact with support and heater platform 100.

Support and heating platform 100 may also be independently raised, via lifting means 110, to a position where it contacts the backside of wafer 30, as shown in Figure 5. Lifting means 110 may, for example, comprise a fluid power cylinder coupled to platform 100 via a hollow shaft or rod 114. It will be noted that when support and heating platform 100 is lifted to a wafer support position beneath target 60, in preparation for deposition onto wafer 30, that ring support member 50 is lowered to permit the forming of a good seal between the underside of wafer 30 and the edge of platform 100 as will be explained below.

Platform 100 contains heating means 120 comprising an electrical resistance heater electrically connected through hollow shaft 114 to a heater power supply 124. After heater means 120 is moved into contact with wafer 30, it serves to heat wafer 30 during the second step of the sputter deposition process and then to maintain the wafer at the heater temperature throughout the remainder of the process though gas flowing from port 106 to thermally couple wafer 30 to heater 120 and platform 100 as will be described below. Platform 100 may be further provided with cooling means such as water cooling coils (not shown) to further stabilize the temperature of platform 100 via the same thermal coupling.

To raise and then stabilize the temperature of wafer 30 during that portion of the sputtering process of the invention when platform 100 is in the raised position, platform 100 is further provided with a crown 104 adjacent the edge of the convex top surface 102 of platform 100 which cooperates with clamping ring 80 to seal the edges of the back surface of wafer 30 to top surface 102 of platform 100, thereby defining a sealed chamber between the back surface of wafer 30 and top surface 102 into which a thermally conductive gas, such as argon, may be admitted through opening 106 in top surface 102 to maintain the temperature of the wafer at a temperature not exceeding the temperature of heating means 120 during a portion of the process, as will be described below.

The thermally conductive gas is supplied from a gas source 108, which also serves as the source for the sputtering gas entering chamber 40 through port 44 as previously described. The thermally conductive gas, which flows through hollow shaft 114 to outlet 106, serves to thermally couple wafer 30 to platform 100. As excess heat builds up in wafer 30 during the sputtering process of the invention, such heat is transmitted through the gas from wafer 30 to platform 100 which is much more massive than the wafer and therefore acts as a large heat sink to absorb the additional heat as it is generated.

### b) First Deposition Step of the Process

As previously mentioned, the multistep aluminum sputtering process of the invention may be carried out using more that one chamber, but preferably is carried out using a single chamber to avoid contamination of the surface of the newly deposited aluminum. Therefore, it will be understood that the following description of the three process steps of the preferred embodiment of the invention refer to the use of a single deposition chamber for all three deposition steps.

The multistep sputtering process of the invention is carried out by first sputtering aluminum onto the wafer surface for a period of time of from about 0.1 to about 0.3 minutes (from about 6 to about 18 seconds), typically about 0.2 minutes (about 12 seconds).

The target power supply is set at a voltage of about -300 to about -600 volts, more preferably from about -450 to about -550 volts, and most preferably about -500 volts; and at a power level sufficient to provide a deposition rate of from about 20 to about 30 NM (200 to about 300 Angstroms) per second. For a 15.24cm (6") diameter wafer, for example, such a deposition rate made be maintained using a power level of from about 9 kilowatt to about 17 kilowatts, typically about 10 kilowatts during the first deposition step.

This time period and deposition rate is sufficient to form an initial aluminum layer having a thickness ranging from about 100 to about 300 NM (1000 to about 3000 Angstroms) in thickness, typically about 200 NM (2000 Angstroms).

During this first deposition step, the temperature of the wafer is maintained at less than about 150°C by keeping support and heating platform 100 away from wafer 30, i.e., by not raising platform 100 (which contains heater 120) into a position in contact with wafer 30, as shown in Figure 4.

The pressure within the sputtering chamber, during this first sputtering step, as well as throughout the remainder of the process, is maintained within a range of from about 1.3 * 10⁻⁶bar to about 10.4 * 10⁻⁶bar (1 to about 8 millitorr) while a sputtertng gas such as argon is flowed into the sputtering chamber at a rate of from about 15 standard cubic centimeters/minute (sccm) to about 300 sccm.

To carry out the first step of the sputtering deposition process of the invention, the wafer is initially loaded onto ring support member 50 in chamber 40 from a load lock vacuum chamber and chamber 40 is then initially evacuated down to at least about 1.333 * 10⁻⁸mb (10⁻⁸Torr) to remove substantially all contaminants from the deposition chamber. Before insertion of wafer 30 into chamber 40, heater means 120 in platform 100 has already heated platform 100 to from about 475°C to about 600°C, preferably from about 500°C to about 550°C, for a purpose which will explained in more detail below with respect to the second deposition step.

After insertion of wafer 30 into chamber 40 and onto ring support member 50, wafer 30 is raised to the sputtering position shown in Figure 4 by admitting fluid pressure into bellows member 58 to raise ring support member 50 with wafer 30 thereon to the sputtering position shown in Figure 4.

The first step of the deposition process then begins by flowing a sputtering gas such as argon into the chamber within the previously discussed flow range and igniting a plasma between target 60 and the grounded portions of chamber 40 exposed to target 60, principally shield 70, while maintaining chamber 40 at the desired pressure range of from about 1.3 * 10⁻⁶bar to 10.4 * 10⁻⁶bar (1 milliTorr to about 8 milliTorr). This first deposition step is then carried out, as stated above, for a time period of from 0.1 to 0.3 minutes.

### c) Second Deposition Step

The second aluminum deposition step is now carried out in deposition chamber 40 with the maximum wafer temperature maintained at a level of from about 475°C to about 600°C, preferably from about 500°C to about 550°C. This may be accomplished by moving or raising support and heating platform 100 into the position shown in Figure 5 wherein the backside of wafer 30 is contacted by raised crown 104 on front surface 102 of platform 100.

As referred to above, heater 120 in platform 100 is maintained at a temperature hotter than the desired wafer temperature during the first step of the process. This is because the heater temperature must be at a higher temperature during the second and third steps in the process and it would be impossible to maintain the heater at a lower temperature during the first step of the process and then heat it further prior, i.e., to a higher temperature, during the second or third steps, given the speed of the steps of the invention.

Thus, while the heater is maintained at the same temperature, i.e., from about 500°C to about 600°C, during the entire process, the spacing of platform 100 from wafer 30 during the first step, as well as the absence of conductive heat coupling or transmission during the first deposition step, accomplishes the desired purpose of maintaining the wafer temperature lower during the first deposition step than the temperature during the remainder of the process.

The wafer temperature is raised during this second deposition step and then maintained within the desired temperature of not exceeding about 600°C, i.e. within a range of from about 475°C to about 600°C, by flowing a thermally conductive gas such as argon through port 106 into the sealed region between wafer 30 and surface 102 of platform 100. This thermally couples wafer 30 to platform 100 and heater 120 to thereby limit further increases in the wafer temperature.

A lower target power level is used in the second step to provide a deposition rate of from about 2 to about 4 NM (20 to about 40 Angstroms). For example, for a 15.24cm (6") wafer, the power level will range from about 1 kilowatt up to about 3 kilowatts, and typically will be about 2 kilowatts, during this second deposition step.

This second deposition step is carried out in deposition chamber 40 for a period of from about 0.6 to 1.1 minutes (from about 36 to about 66 seconds), preferably from about 0.7 to about 1.0 minutes (from about 42 to about 60 seconds). This results in the further deposition of from about 100 to about 300 NM (1000 to about 3000 Angstroms) of additional aluminum, typically about 200 NM (2000 Angstroms), which is sputtered onto wafer 30 over the previously deposited aluminum.

### d) Third Deposition Step

When the second step of the sputtering process of the invention has been terminated, the third step is commenced, which comprises a further deposition of at least about 300 NM (3000 Angstroms) of additional aluminum onto the wafer surface, using a higher target power level. This third deposition step may be carried out for a period of from about 0.3 to about 0.4 minutes (from about 18 to about 24 seconds), or until a total deposit thickness of from about 0.6 to 2 micrometers is reached, still using deposition chamber 40, to deposit additional aluminum using a target power level sufficient to provide a deposition rate of from about 10 NM (100 Angstroms) per second to about 25 NM (250 Angstroms) per second. For a 15.24cm (6") wafer, for example, the power level will range from about 4 to about 17 kilowatts, and typically will be about 9 kilowatts. If it is desired to deposit additional aluminum on the surface of the wafer during this third deposition step, the length of the deposition time period of this third step may be appropriately extended.

The wafer temperature is maintained during this third deposition step at the same level as during the second deposition step, i.e. at a level of from about 475°C to about 600°C, preferably from about 500°C to about 550°C, with the maximum wafer temperature not exceeding about 600°C. If need be, the power level may be reduced during this third step to maintain the wafer temperature within the recited temperature limits.

With respect to the deposition of aluminum during the third step, the minimum total amount of aluminum to be sputtered over the wafer will depend to some extent on the underlying topography of the wafer. The minimum total thickness of the deposited aluminum layer over the low areas of the wafer between closely spaced apart raised portions of the wafer should be at least 80%, and preferably from about 100 to 200%; of the depth of the via or trench or height of the lines on the wafer.

Using the above procedure, an aluminum layer is deposited, which may have an average thickness of at least about 0.6 to about 2 µm, and usually averaging about 1.0 µm, over the highest portions of the underlying semiconductor wafer. The deposited aluminum layer substantially completely fills in the low areas between such closely spaced apart raised portions on the wafer and does not form negative slopes over such low regions of the wafer.

It should be noted, in this regard, that using the process of the invention, straight wall trenches and regions between closely spaced apart vertical raised lines having aspect ratios (height/width) as high as 1.2 can be satisfactorily filled with aluminum without experiencing the prior art thinning of the aluminum layer previously discussed, and if the walls are tapered down to an angle of about 80° or less to the horizontal, trenches and regions between raised lines having aspect ratios as high as 1.5 (as measured at the bottom of the trench or region between raised lines) can be satisfactorily filled with aluminum using the process of the invention.

similarly, straight walled vias having aspect ratios as high as 0.83 can be satisfactorily filled using the process of the invention while tapered vias, having walls forming an angle of 70° or less to the horizontal, may be satisfactorily filled in accordance with the invention even with aspect ratios as high as 1.2.

It should also be noted, that by using a single deposition chamber for all three steps of the deposition process, the deposition may be carried out on a continuous basis, which forms one of the principal advantages of the use of a single chamber. By continuing the aluminum deposition, even while changing the deposition parameters, e.g., wafer temperature and target power level, contamination of the aluminum being deposited is further inhibited.

This is because the aluminum is continuously being deposited so that aluminum on the surface does not have an opportunity to react with any possible contaminants, e.g., oxygen atoms. In contrast, when more that one chamber is used, the deposition process must be stopped while the wafer is shifted from one chamber to another. This provides a time period during which the aluminum atoms on the surface can react with any contaminating atoms in the vacuum apparatus. Because of this cessation of the deposition, it is very important that during the transfer of the wafer, the wafer be maintained under high vacuum to avoid contamination, as will be discussed below.

### e. Use of More Than One Deposition Chamber

While the use of a single deposition chamber for all three deposition steps is preferred, it is within the contemplation of the invention to carry out the above described first deposition step in a separate sputter deposition chamber, and then to move the wafer to a second deposition chamber (which may be contained within the same vacuum apparatus to thereby inhibit contamination of the wafer).

When it is desired to use one chamber for the initial step, followed by transfer of the wafer, under vacuum, to a second chamber, both chambers may utilize the same form of wafer handling and deposition apparatus, but the wafer deposition position shown in Figure 4 need not be used. For each deposition, wafer 30 and wafer support and heater 100 may be raised to the deposition position shown in Figure 5 and thermally conductive gas flowed through port 106 to the backside of the wafer.

Heater 100 in one chamber would then be maintained at the desired temperature for the first deposition step, while heater 100 in the second deposition chamber would be maintained at the desired temperature for the second and third deposition steps.

When more than one deposition chamber is used for the aluminum deposition process of the invention, the process parameters may be altered slightly to compensate for not maintaining the plasma continuously. For example, for the first deposition step, the wafer may be maintained at a temperature below about 100°C, by adjusting the heater temperature in that deposition chamber accordingly. Other parameters, such as deposit rate and total deposit time, may also be different for the first deposition step of the process when it is carried out in a separate deposition chamber.

For example, a lower deposition rate of, for example, about 10 NM (100 Angstroms) per second, may be used for this first step in the two chamber process if desired, until a deposit of about 200 NM (2000 Angstroms) is reached, thus lengthening the total deposition time in the first chamber. The target power level will be maintained in the first chamber within a range of from 1 kilowatt to about 20 kilowatts.

When a multiple chamber deposition is carried out, the wafer is transferred from the first deposition chamber to the second deposition chamber through an interconnecting vacuum chamber under a vacuum which should range from about 1.333 * 10⁻⁸mb to about 1.333 * 10⁻⁹mb (10⁻⁸ to about 10⁻⁹ Torr) to avoid contamination of the aluminum surface of the wafer during the transfer step. As discussed above, when a single deposition step is used, the deposition process may be carried out on a continuous basis to minimize contamination of the aluminum as it is being formed. Therefore, since the deposition process must be interrupted when a multiple chamber deposition is carried out, it is very important that precautions be exercised to prevent contamination during the deposition process which, unlike the single chamber deposition process, could occur during the transfer of the wafer from one deposition chamber to another, unless the stated high vacuum is maintained.

Vacuum apparatus having such a vacuum interconnecting chamber, which permits the transfer of a wafer from one vacuum chamber to another while maintaining the wafer under high vacuum, is described in Toshima U.S. Patent 4,785,962 and Maydan et al, U.S. Patent 4,951,601, both assigned to the assignee of the present invention, and cross-reference to both of which is hereby made.

After transferring the wafer to the second deposition chamber, the wafer temperature may be brought up to a temperature of about 530°C to about 600°C (by contact with heater 100 in the second chamber) over a period of about 50 seconds, while optionally depositing aluminum at a rate of from 0 to about 4 NM (0 to about 40 Angstroms) per second. As previously described, a lower target power level is used during the second deposition step. For example, for a 15.24cm (6") wafer, the power level will range from about 1 kilowatt up to about 3 kilowatts, and typically will be about 2 kilowatts, during this second deposition step.

After the 50 second time period the deposition rate may be raised to from about 10 to about 30 NM (100 to about 300 Angstroms) per second and maintained at this rate, and at a temperature not exceeding 600°C until from about 0.6 to about 2 micrometers of aluminum has been deposited. During this third deposition step the target power level will be maintained, for example, for a 15.24cm (6") wafer, within a range of from about 4 to about 17 kilowatts, typically about 9 kilowatts, as in the previously described parameters for the third step in the single chamber process.

The following examples will serve to further illustrate the process of the invention.

### Example I

A 0.6 mm silicon wafer was loaded into a sputtering chamber such as previously described. The wafer had a series of 1 µm high and 1.2 µm wide silicon oxide steps formed thereon with a spacing between the steps of about 1 µm.

The sputtering chamber pressure was maintained at about 3.9 * 10⁻⁶bar (3 milliTorr) during the deposition process.
The target power supply was initially set at 10 kilowatts with a -428 volt DC target voltage. The heater temperature was maintained throughout the deposition at 600°C resulting in an overall temperature of the sputtering chamber of about 600°C. After loading the wafer into the chamber, the wafer support ring with the wafer thereon was raised to move the wafer into the sputtering position. Argon gas was then flowed through the chamber at 100 sccm. The plasma was then ignited and aluminum was sputtered onto the wafer at this power level for about 12 seconds, resulting in the deposition of about 200 NM (2000 Angstroms) of aluminum on the wafer.

The power level of the target power supply was then reduced to about 2 kilowatts and the support platform containing the heater was moved up into contact with the backside of the wafer, after which argon gas was admitted to the region between the backside of the wafer and the support platform to raise the wafer temperature up to about 600°C during the second deposition step. The wafer was then sputtered for an additional 48 seconds at this power level, resulting in the deposition of an additional 200 NM (2000 Angstroms) of aluminum over the wafer.

The sputtering process was then continued in a third deposition step under the same conditions as in the second step, except that the target power level was raised to about 9 kilowatts. The deposition was carried out for an additional 12 seconds (a total of 72 seconds for all three steps), to deposit another 300 NM (3000 Angstroms) of aluminum on the wafer surface, a total of 900 NM (9000 Angstroms).

The wafer was then removed from the chamber, sectioned, and examined under a scanning electron microscope (SEM). The low ares between the closely spaced apart steps were found to be completely filled with aluminum, with no visible evidence of void formation and the slope of the deposited aluminum layer over the low regions was positive.

### Example II

To illustrate the use of two deposition chambers, a 0.6 mm silicon wafer substantially identical to that utilized in Example I was loaded into a first sputtering chamber such as previously described, but with the heater maintained at a temperature of about 50°C. In this instance, the heater was moved up to contact the wafer and gas was flowed across the backside of the wafer during the first deposition step to maintain the wafer at 50°C. The sputtering chamber pressure was maintained at about 3.9 * 10⁻⁶bar (3 milliTorr) during the deposition and about 200 NM (2000 Angstroms) of aluminum was sputtered onto the wafer under the same conditions used in the first step of Example I.
The coated wafer was then removed from this first sputtering chamber and moved to a second sputtering chamber within the same vacuum apparatus through an interconnecting chamber maintained between 1.333 * 10⁻⁸mb to 1.333 * 10⁻⁹mb ( 10⁻⁸ to 10⁻⁹ Torr) to avoid contaminating the aluminum on the wafer. The second chamber was identical to the first chamber, except that the heater in the second chamber was maintained at a temperature of about 600°C during the second and third deposition steps. The second chamber was also maintained at a pressure of about 3.9 * 10⁻⁶bar (3 milliTorr) during both the second and third deposition steps. Additional aluminum was sputtered onto the wafer in two steps identical to the second and third deposition steps described in Example I, except that the second step was carried out for about 50 seconds and the third deposition step was carried out until a total thickness of 1 micrometer was reached.

As in the previous example, the wafer was subsequently removed from the chamber, sectioned, and examined under a scanning electron microscope (SEM). The low ares between the closely spaced apart steps were again found to be completely filled with aluminum, with no visible evidence of void formation and the slope of this deposited aluminum layer over the low regions was also positive.

Thus, the invention provides a novel aluminum sputtering process wherein regions between closely spaced apart raised portions on a semiconductor wafer may be substantially completely filled with aluminum and negative slopes on the deposited aluminum layers over low areas between closely spaced apart raised portions of the wafer may be avoided, without applying a bias voltage to the wafer during the deposition process, i.e., without bombarding the surface of the wafer with ions.

## Claims

1. A sputtering process for depositing an aluminum layer over a semiconductor wafer, without applying a bias voltage to the wafer, which process comprises:
(a) sputtering aluminum from a target onto said wafer in a first deposition step for a time period from 0.1 to 0.3 minutes while maintaining a target power level sufficient to provide a deposition rate of from 20 to 30 NM (200 to 300 Angstroms) per second, and while maintaining the wafer at a temperature less than about 150°C;
(b) changing the target power level range to provide a deposition rate of from 2 to 4 NM (20 to 40 Angstroms) per second and sputtering additional aluminum onto the wafer in a second deposition step for a time period of from 0.6 to 1.1 minutes, while raising the wafer to a temperature of from 475°C to about 600°C and then maintaining the wafer at this temperature; and
(c) then raising the target power level range to provide a deposition rate of from 10 to 25 NM (100 to 250 Angstroms) per second and sputtering further aluminum onto the wafer surface in a third deposition step, while continuing to maintain said wafer at a temperature of from 475°C to about 600°C.

2. The process of claim 1 wherein said wafer temperature is raised, and then maintained at said temperature of from 475°C to about 600°C during said second and third deposition steps, by contacting the backside of said wafer with a thermally conductive gas.

3. The process of one of the preceding claims wherein said first step is carried out until from 100 to 300 NM (1000 to 3000 Angstroms) of aluminum has been deposited on said wafer.

4. The process of one of the preceding claims wherein said second step is carried out until from 100 to 300 NM (1000 to 3000 Angstroms) of additional aluminum has been deposited on said wafer.

5. The process of one of the preceding claims wherein the target voltage is maintained within a range of from -300 volts to -600 volts at least during the first step of the process.

6. The process of one of the preceding claims wherein the pressure in said sputtering chamber is maintained within a range of from 1.3 * 10 ⁻⁶bar to 10.4 * 10 ⁻⁶bar (1 milliTorr to 8 milliTorr) throughout the process.

7. The process of one of the preceding claims wherein said wafer temperature is raised, and then maintained at said temperature of from 475°C to about 600°C during said second and third deposition steps, by thermally coupling said wafer to a heater located in a wafer support platform during said second and third deposition steps.

8. The process of claim 7 wherein said wafer support platform and heater therein are initially heated to a temperature of from 475°C to about 600°C prior to said first sputtering step.

9. The process of claim 8 wherein said wafer support platform and heater therein are spaced from said wafer during said first deposition step.

10. The process of claim 9 wherein said wafer support platform is raised to engage the backside of said wafer during said second and third deposition steps.

11. The process of claim 10 wherein thermally conductive gas is admitted to a sealed region between the upper surface of said wafer support platform and the backside of said wafer during said second and third deposition steps to thermally couple said wafer to said support platform and said heater therein.

12. The process of claim 9 or 10 wherein said thermally conductive gas couples said wafer to said heater maintained at a temperature of from 475°C to about 600°C.

13. The process of one of the preceding claims wherein said first deposition step is carried out in a vacuum chamber wherein said wafer is maintained at a temperature not exceeding about 100°C and said wafer is then moved, under vacuum, to a second chamber where said second and third deposition steps are carried out.

14. The process of claim 13 wherein said wafer is maintained at said temperature during said first deposition step by thermally coupling said wafer to a heater located in a wafer support platform in said chamber.

15. The process of claim 14 wherein said wafer temperature before commencing said first deposition step does not exceed about 100°C.

16. The process of claim 15 wherein said step of moving said wafer, under vacuum, to a second chamber where said second and third deposition steps are carried out, further comprises transferring said wafer under a vacuum within a range of from 1.333 * 10⁻⁸mb to 1.333 * 10⁻⁹mb (10⁻⁸ to 10-⁹ Torr).

17. A process in accordance with claim 1 for sputtering an aluminum layer having a substantially planar surface over a semiconductor wafer having closely spaced apart raised portions, without applying a bias voltage to said wafer, which comprises:
(a) heating a wafer support platform having heater means therein in a sputtering chamber to a temperature of from 500°C to 600°C;
(b) inserting a semiconductor wafer having closely spaced apart raised portions into said sputtering chamber having an aluminum target therein connected to a target power supply capable of maintaining the voltage on said target within a range of from -300 to -600 volts DC throughout the sputtering process;
(c) flowing a source of sputtering gas into said chamber at a rate of from 15 to 300 sccm while maintaining said chamber at a pressure within a range of from 1.3 * 10⁻⁶bar to 10.4 * 10⁻⁶bar (1 milliTorr to 8 milliTorr);
(d) igniting a plasma in said chamber to sputter aluminum from said target onto said wafer in a first deposition step for from 0.1 to 0.3 minutes while maintaining a power level on said target sufficient to provide a deposition range of 20 to 30 NM (200 to 300 Angstroms) per second and while maintaining said wafer at a temperature less than about 150°C by spacing said wafer from said heated support platform;
(e) then raising said heated support platform to contact the backside of said wafer;
(f) flowing thermally conductive gas to a sealed region between the upper surface of said wafer support platform and the backside of said wafer to thermally couple said wafer to said support platform and said heater means therein to thereby raise the temperature of said wafer to a temperature from 475°C to about 600°C;
(g) changing the target power level range to provide a deposition rate of from 2 to 4 NM (20 to 40 Angstroms) per second and sputtering additional aluminum onto the wafer in a second deposition step for from 0.7 to 1.1 minutes, while maintaining said wafer at said temperature of from 475°C to about 600°C; and
(h) then raising the target power level range sufficiently to provide a deposition rate of from 10 to 25 NM (100 to 250 Angstroms) per second and sputtering further aluminum onto the wafer surface in a third deposition step, while continuing to maintain said wafer at a temperature of from 475°C to 600°C until a final average thickness of about 1 to about 2 µm of aluminum has been deposited.

18. The process of claim 17 including the further step of moving said wafer in said chamber to a sputter deposition position in said chamber prior to said first deposition step.

19. A process in accordance with claim 1 for sputtering an aluminum layer having a substantially planar surface over a semiconductor wafer having closely spaced apart raised portions, without applying a bias voltage to said wafer, which comprises:
(a) inserting a semiconductor wafer having closely spaced apart raised portions into a first sputter deposition chamber maintained at a pressure of from 1.3 * 10⁻⁶ bar to 10.4 * 10⁻⁶ bar (1 to 8 milliTorr) and a temperature not exceeding about 100°C, said first chamber having an aluminum target therein connected to a target power supply capable of maintaining the target voltage within a range of from -300 to -600 volts DC;
(b) igniting a plasma in said chamber to sputter aluminum from said target onto said wafer in a first deposition step for a period of from 0.1 to 0.3 minutes while maintaining said wafer at a temperature less than about 100°C to deposit up to about 200 NM (2000 Angstroms) of aluminum on said wafer at a rate of from 20 to 30 nm (200 to 300 Angstroms) per second;
(c) removing said wafer from said first chamber, under a vacuum ranging from 1.333 * 10⁻⁸ to 1.333 * 10⁻⁹mb (10⁻⁸ to 10⁻⁹ Torr), and inserting said wafer into a second sputter deposition chamber containing a sputtering gas and heated to a temperature of from 500°C to 600°C, while maintaining a pressure therein within a range of from 1.3 * 10⁻⁶bar to 10.4 * 10⁻⁶ bar (1 milliTorr to 8 milliTorr), said second chamber also having an aluminum target therein connected to a target power supply capable of maintaining the target voltage within a range of from -300 to -600 volts DC;
(d) sputtering additional aluminum onto said wafer in a second deposition step for a period of from 0.7 to 1.1 minutes, while maintaining the power level range on said target in said second chamber at a level sufficient to provide a deposition rate of from 2 to about 4 NM (20 to about 40 Angstroms) per second, and while maintaining said wafer at a temperature of from 500°C to 600°C; and
(e) then raising the target power level range to a level which will provide a deposition rate of from 10 to 30 NM (100 to 300 Angstroms) per second, and sputtering further aluminum onto the wafer surface in said second deposition chamber in a third deposition step, while continuing to maintain said wafer at a temperature of from 500°C to 600°C.

20. The process of claim 19 wherein said wafer is heated to said temperatures and maintained at said temperatures during said second and third deposition steps by contacting the backside of said wafer with a heated wafer support platform containing a heater therein and flowing a thermally conductive gas to a sealed region between an upper surface of said wafer support platform and said backside of said wafer to thermally couple said wafer to said support platform and said heater therein.

## Patentansprüche

1. Sputterverfahren zur Ablagerung einer Aluminiumschicht über einem Halbleiterwafer ohne Anlegen einer Spannung an den Wafer, wobei das Verfahren folgendes umfaßt:
(a) Sputtern von Aluminium von einem Target auf den Wafer in einem ersten Ablagerungsschritt über einen Zeitraum von 0,1 bis 0,3 Minuten, während ein Targetleistungspegel aufrechterhalen wird, welcher zur Gewährleistung einer Ablagerungsgeschwindigkeit von 20 bis 30 NM (200 bis 300 Ångström) pro Sekunde ausreicht, und während der Wafer bei einer Temperatur unter etwa 150°C gehalten wird;
(b) Änderung des Targetleistungspegelbereichs zur Gewährleistung einer Ablagerungsgeschwindigkeit von 2 bis 4 NM (20 bis 40 Ångström) pro Sekunde und Sputtern von weiterem Aluminium auf den Wafer in einem zweiten Ablagerungsschritt über einen Zeitraum von 0,6 bis 1,1 Minuten, während die Temperatur des Wafers auf 475°C bis etwa 600 °C erhöht wird und anschließend der Wafer auf dieser Temperatur gehalten wird; und
(c) anschließende Erhöhung des Targetleistungspegelbereichs zur Gewährleistung einer Ablagerungsgeschwindigkeit von 10 bis 25 NM (100 bis 250 Ångström) pro Sekunde und Sputtern von weiterem Aluminium auf die Waferoberfläche in einem dritten Ablagerungsschritt, während der Wafer weiterhin auf einer Temperatur von 475°C bis etwa 600°C gehalten wird.

2. Verfahren gemäß Anspruch 1, bei dem eine Erhöhung der Wafertemperatur und anschließende Aufrechterhaltung bei der Temperatur von 475°C bis etwa 600°C während des zweiten und dritten Ablagerungsschritts erfolgt, indem die Rückseite des Wafers mit einem thermisch leitenden Gas in Berührung kommt.

3. Verfahren gemäß einem der vorhergehenden Ansprüche, bei dem der erste Schritt ausgeführt wird, bis eine Ablagerung von 100 bis 300 NM (1000 bis 3000 Ångström) Aluminium auf dem Wafer erfolgt ist.

4. Verfahren gemäß einem der vorhergehenden Ansprüche, bei dem der zweite Schritt ausgeführt wird, bis eine Ablagerung von 100 bis 300 NM (1000 bis 3000 Ångström) von weiterem Aluminium auf dem Wafer erfolgt ist.

5. Verfahren gemäß einem der vorhergehenden Ansprüche, bei dem die Targetspannung zumindest während des ersten Schritts des Verfahrens in einem Bereich von -300 Volt bis -600 Volt gehalten wird.

6. Verfahren gemäß einem der vorhergehenden Ansprüche, bei dem der Druck in der Sputterkammer während des gesamten Verfahrens in einem Bereich von 1,3 * 10⁻⁶ Bar bis 10,4 * 10⁻⁶ Bar (1 Millitorr bis 8 Millitorr) gehalten wird.

7. Verfahren gemäß einem der vorhergehenden Ansprüche, bei dem eine Erhöhung der Wafertemperatur und anschließende Aufrechterhaltung bei der Temperatur von 475°C bis etwa 600°C während des zweiten und dritten Ablagerungsschritts erfolgt, indem der Wafer während des zweiten und dritten Ablagerungsschritts thermisch mit einer in einer Waferhalterplatte befindlichen Heizeinrichtung verbunden wird.

8. Verfahren gemäß Anspruch 7, bei dem die Waferhalterplatte und die darin befindliche Heizeinrichtung vor dem ersten Sputterverfahren anfänglich auf eine Temperatur von 475°C bis etwa 600°C erwärmt werden.

9. Verfahren gemäß Anspruch 8, bei dem die Waferhalterplatte und die darin befindliche Heizeinrichtung während des ersten Ablagerungsschritts von dem Wafer beabstandet sind.

10. Verfahren gemäß Anspruch 9, bei dem die Waferhalterplatte zum Eingriff der Rückseite des Wafers während des zweiten und dritten Ablagerungsschritts angehoben wird.

11. Verfahren gemäß Anspruch 10, bei dem thermisch leitendes Gas während des zweiten und dritten Ablagerungsschritts in einen geschlossenen Bereich zwischen der oberen Oberfläche der Waferhalterplatte und der Rückseite des Wafers eingelassen wird, um den Wafer thermisch mit der Halterplatte und der darin befindlichen Heizeinrichtung zu verbinden.

12. Verfahren gemäß Anspruch 9 oder 10, bei dem das thermisch leitende Gas den Wafer mit der Heizeinrichtung verbindet, welche auf einer Temperatur von 475°C bis etwa 600°C gehalten wird.

13. Verfahren gemäß einem der vorhergehenden Ansprüche, bei dem der erste Ablagerungsschritt in einer Vakuumkammer erfolgt, wobei der Wafer auf einer Temperatur von nicht mehr als etwa 100°C gehalten wird, und der Wafer anschließend unter Vakuum zu einer zweiten Kammer bewegt wird, wo der zweite und der dritte Ablagerungsschritt erfolgen.

14. Verfahren gemäß Anspruch 13, bei dem der Wafer während des ersten Ablagerungsschritts durch thermisches Verbinden des Wafers mit einer Heizeinrichtung in einer Waferhalterplatte in der Kammer auf der genannten Temperatur gehalten wird.

15. Verfahren gemäß Anspruch 14, bei dem die Wafertemperatur vor Beginn des ersten Ablagerungsschritts nicht über etwa 100°C liegt.

16. Verfahren gemäß Anspruch 15, bei dem der Schritt der Bewegung des Wafers unter Vakuum zu einer zweiten Kammer, wo der erste und der zweite Ablagerungsschritt erfolgen, des weiteren die Übertragung des Wafers unter einem Vakuum im Bereich von 1,333 * 10⁻⁸ mb bis 1,333 * 10⁻⁹ mb (10⁻⁸ bis 10⁻⁹ Torr) umfaßt.

17. Verfahren gemäß Anspruch 1 zum Sputtern einer Aluminiumschicht mit einer im wesentlichen ebenen Oberfläche über einen Halbleiterwafer mit eng beabstandeten erhöhten Bereichen, ohne an den Wafer eine Spannung anzulegen, das folgendes umfaßt:
(a) Erwärmen einer Waferhalterplatte mit einem darin befindlichen Heizmittel in einer Sputterkammer auf eine Temperatur von 500°C bis 600°C;
(b) Einsetzen eines Halbleiterwafers mit eng beabstandeten erhöhten Bereichen in die Sputterkammer mit einem darin befindlichen Aluminiumtarget, welches mit einer Targetspannungsquelle verbunden ist, womit die Spannung an dem Target in einem Bereich von -300 bis -600 Volt Gleichspannung während des gesamten Sputterverfahrens gehalten werden kann;
(c) Strömen einer Sputtergasquelle in die Kammer bei einer Rate von 15 bis 300 sccm, während die Kammer bei einem Druck im Bereich von 1,3 * 10⁻⁶ bar bis 10,4 * 10⁻⁶ bar (1 Millitorr bis 8 Millitorr) gehalten wird;
(d) Zünden eines Plasmas in der Kammer zum Sputtern von Aluminium von dem Target auf den Wafer in einem ersten Ablagerungsschritt über einen Zeitraum von 0,1 bis 0,3 Minuten, während ein Leistungspegel an dem Target aufrechterhalten wird, welcher zur Gewährleistung eines Ablagerungsbereichs von 20 bis 30 NM (200 bis 300 Ångström) pro Sekunde ausreicht, und während der Wafer auf einer Temperatur von weniger als etwa 150°C gehalten wird, indem der Wafer von der erwärmten Halterplatte beabstandet wird;
(e) anschließendes Anheben der erwärmten Halterplatte zur Kontaktierung der Rückseite des Wafers;
(f) Strömen von thermisch leitendem Gas in einen abgedichteten Bereich zwischen der oberen Oberfläche der Waferhalterplatte und der Rückseite des Wafers, um den Wafer thermisch mit der Halterplatte und der darin befindlichen Heizeinrichtung zu verbinden, um somit die Temperatur des Wafers auf eine Temperatur von 475°C bis etwa 600°C zu erhöhen;
(g) Änderung des Targetleistungspegelbereichs zur Gewährleistung einer Ablagerungsgeschwindigkeit von 2 bis 4 NM (20 bis 40 Ångström) pro Sekunde und Sputtern von weiterem Aluminium auf den Wafer in einem zweiten Ablagerungsschritt über einen Zeitraum von 0,7 bis 1,1 Minuten, während der Wafer auf der Temperatur von 475°C bis etwa 600 °C gehalten wird; und
(h) anschließende ausreichende Erhöhung des Targetleistungspegelbereichs zur Gewährleistung einer Ablagerungsgeschwindigkeit von 10 bis 25 NM (100 bis 250 Ångström) pro Sekunde und Sputtern von weiterem Aluminium auf die Waferoberfläche in einem dritten Ablagerungsschritt, während der Wafer weiterhin auf einer Temperatur von 475°C bis 600°C gehalten wird, bis eine endgültige durchschnittliche Dicke von etwa 1 bis etwa 2 µm Aluminium abgelagert worden ist.

18. Verfahren gemäß Anspruch 17 mit dem weiteren Schritt der Bewegung des Wafers in der Kammer zu einer Sputterablagerungsposition in der Kammer vor dem ersten Ablagerungsschritt.

19. Verfahren gemäß Anspruch 1 zum Sputtern einer Aluminiumschicht mit einer im wesentlichen ebenen Oberfläche über einen Halbleiterwafer mit eng beabstandeten erhöhten Bereichen, ohne an den Wafer eine Spannung anzulegen, das folgendes umfaßt:
(a) Einsetzen eines Halbleiterwafers mit eng beabstandeten erhöhten Bereichen in eine erste Sputterablagerungskammer, welche auf einem Druck von 1,3 * 10⁻⁶ bar bis 10,4 * 10⁻⁶ bar (1 bis 8 Millitorr) und einer nicht über 100°C liegenden Temperatur gehalten wird, wobei sich in der ersten Kammer ein Aluminiumtarget befindet, welches mit einer Targetspannungsquelle verbunden ist, womit die Targetspannung in einem Bereich von -300 bis -600 Volt Gleichspannung gehalten werden kann;
(b) Zünden eines Plasmas in der Kammer zum Sputtern von Aluminium von dem Target auf den Wafer in einem ersten Ablagerungsschritt über einen Zeitraum von 0,1 bis 0,3 Minuten, während der Wafer auf einer Temperatur von weniger als etwa 100°C gehalten wird, um bei einer Geschwindigkeit von 20 bis 30 NM (200 bis 300 Ångström) pro Sekunde bis zu etwa 200 NM (2000 Ångström) Aluminium auf dem Wafer abzulagern;
(c) Entnehmen des Wafers aus der ersten Kammer, unter einem Vakuum von 1,333 * 10⁻⁸ bis 1,333 * 10⁻⁹ mb (10⁻⁸ bis 10⁻⁹ Torr), und Einsetzen des Wafers in eine zweite Sputterablagerungskammer, welche ein Sputtergas enthält und auf eine Temperatur von 500°C bis 600°C erwärmt ist, während ein Druck im Bereich von 1,3 * 10⁻⁶ bar bis 10,4 * 10⁻⁶ bar (1 Millitorr bis 8 Millitorr) darin aufrechterhalten wird, wobei sich in der zweiten Kammer ebenso ein Aluminiumtarget befindet, welches mit einer Targetspannungsquelle verbunden ist, womit die Targetspannung in einem Bereich von -300 bis -600 Volt Gleichspannung gehalten werden kann;
(d) Sputtern von weiterem Aluminium auf den Wafer in einem zweiten Ablagerungsschritt über einen Zeitraum von 0,7 bis 1,1 Minuten, während der Leistungspegelbereich an dem Target in der zweiten Kammer auf einem Pegel aufrechterhalen wird, welcher zur Gewährleistung einer Ablagerungsgeschwindigkeit von 2 bis etwa 4 NM (20 bis etwa 40 Ångström) pro Sekunde ausreicht, und während der Wafer bei einer Temperatur von 500°C bis 600°C gehalten wird; und
(e) anschließende Erhöhung des Targetleistungspegelbereichs auf einen Pegel zur Gewährleistung einer Ablagerungsgeschwindigkeit von 10 bis 30 NM (100 bis 300 Ångström) pro Sekunde und Sputtern von weiterem Aluminium auf die Waferoberfläche in der zweiten Ablagerungskammer in einem dritten Ablagerungsschritt, während der Wafer weiterhin auf einer Temperatur von 500°C bis 600°C gehalten wird.

20. Verfahren gemäß Anspruch 19, bei dem eine Erwärmung des Wafers auf die genannten Temperaturen und eine Aufrechterhaltung dieser Temperaturen während des zweiten und dritten Ablagerungsschritts erfolgt, indem die Rückseite des Wafers mit einer erwärmten Waferhalterplatte mit einer darin befindlichen Heizeinrichtung in Berührung kommt und ein thermisch leitendes Gas in einen abgedichteten Bereich zwischen einer oberen Oberfläche der Waferhalterplatte und der Rückseite des Wafers strömt, um den Wafer mit der Halterplatte und der darin befindlichen Heizeinrichtung thermisch zu verbinden.

## Revendications

1. Procédé de pulvérisation pour déposer une couche d'aluminium sur une plaquette de semi-conducteur, sans appliquer de tension de polarisation à la plaquette, lequel procédé consiste à :
(a) pulvériser de l'aluminium depuis une cible jusque sur ladite plaquette au cours d'une première étape de dépôt, pendant une période de temps qui va de 0,1 à 0,3 minute, tout en maintenant un niveau d'énergie de la cible suffisant pour obtenir une vitesse de dépôt qui va de 20 à 30 nm (de 200 à 300 Angström) par seconde, et tout en maintenant la plaquette à une température inférieure à environ 150°C ;
(b) changer la gamme de niveau d'énergie de la cible pour obtenir une vitesse de dépôt qui va de 2 à 4 nm (de 20 à 40 Angström) par seconde et pulvériser davantage d'aluminium sur la plaquette au cours d'une seconde étape de dépôt, pendant une période de temps comprise entre 0,6 et 1,1 minute, tout en portant la plaquette à une température comprise entre 475°C et environ 600°C puis en maintenant la plaquette à cette température ; et
(c) augmenter ensuite la gamme de niveau d'énergie de la cible pour obtenir une vitesse de dépôt qui va de 10 à 25 nm (de 100 à 250 Angström) par seconde, et pulvériser davantage d'aluminium sur la surface de la plaquette au cours d'une troisième étape de dépôt, tout en continuant à maintenir ladite plaquette a une température comprise entre 475°C et environ 600°C.

2. Procédé selon la revendication 1, dans lequel la température de ladite plaquette est élevée, puis maintenue à ladite température comprise entre 475°C et environ 600°C au cours desdites seconde et troisième étapes de dépôt, en mettant la face arrière de ladite plaquette en contact avec un gaz thermiquement conducteur.

3. Procédé selon l'une des revendications précédentes, dans lequel ladite première étape est mise en oeuvre jusqu'à ce que de 100 à 300 nm (de 1000 à 3000 Angström) d'aluminium ait été déposés sur ladite plaquette.

4. Procédé selon l'une des revendications précédentes, dans lequel ladite seconde étape est mise en oeuvre jusqu'à ce que de 100 à 300 nm (de 1000 à 3000 Angström) d'aluminium supplémentaire ait été déposés sur ladite plaquette.

5. Procédé selon l'une des revendications précédentes, dans lequel la tension cible est maintenue dans la gamme qui va de -300 volts à -600 volts au moins au cours de la première étape du procédé.

6. Procédé selon l'une des revendications précédentes, dans lequel la pression dans la chambre de pulvérisation est maintenue dans la gamme qui va de 1,3 x 10⁻⁶bar à 10,4 x 10⁻⁶ bar (de 1 à 8 milliTorr) tout au long du procédé.

7. Procédé selon l'une des revendications précédentes, dans lequel la température de ladite plaquette est élevée, puis maintenue à ladite température comprise entre 475°C et environ 600°C au cours desdites seconde et troisième étapes de dépôt, en couplant thermiquement ladite plaquette avec un dispositif de chauffage situé dans un plateau de support de plaquette au cours desdites seconde et troisième étapes de dépôt.

8. Procédé selon la revendication 7, dans lequel ledit plateau de support de plaquette et le dispositif de chauffage contenu dans celui-ci sont initialement chauffés à une température comprise entre 475°C et environ 600°C, avant ladite première étape de pulvérisation.

9. Procédé selon la revendication 8, dans lequel ledit plateau de support de plaquette et ledit dispositif de chauffage contenu dans celui-ci sont espacés de ladite plaquette au cours de ladite première étape de dépôt.

10. Procédé selon la revendication 9, dans lequel ledit plateau de support de plaquette est soulevé pour venir en prise avec la face arrière de ladite plaquette au cours desdites seconde et troisième étapes de dépôt.

11. Procédé selon la revendication 10, dans lequel un gaz thermiquement conducteur est admis dans une région hermétiquement fermée comprise entre la surface supérieure dudit plateau de support de plaquette et la face arrière de ladite plaquette, au cours desdites seconde et troisième étapes de dépôt, pour coupler thermiquement ladite plaquette avec ledit plateau de support et ledit dispositif de chauffage contenu dans celui-ci.

12. Procédé selon la revendication 9 ou 10, dans lequel ledit gaz thermiquement conducteur couple ladite plaquette avec ledit dispositif de chauffage maintenu à une température comprise entre 475°C et environ 600°C.

13. Procédé selon l'une des revendications précédentes, dans lequel ladite première étape de dépôt est mise en oeuvre dans une chambre à aspiration dans laquelle ladite plaquette est maintenue à une température qui n'excède pas environ 100°C et ladite plaquette est ensuite déplacée, sous aspiration, jusqu'à une seconde chambre dans laquelle lesdites seconde et troisième étapes de dépôt sont mises en oeuvre.

14. Procédé selon la revendication 13, dans lequel ladite plaquette est maintenue à ladite température au cours de ladite première étape de dépôt en couplant thermiquement ladite plaquette avec un dispositif de chauffage situé dans un plateau de support de plaquette dans ladite chambre.

15. Procédé selon la revendication 14, dans lequel la température de ladite plaquette n'excède pas environ 100°C avant le commencement de ladite première étape de dépôt.

16. Procédé selon la revendication 15, dans lequel ladite étape consistant à déplacer ladite plaquette sous aspiration jusqu'à une seconde chambre, dans laquelle lesdites seconde et troisième étapes de dépôt sont mises en oeuvre, comprend en outre le transfert de ladite plaquette sous une aspiration comprise dans la gamme qui va de 1,333 x 10⁻⁸ mb à 1,333 x 10⁻⁹ mb (de 10⁻⁸ à 10⁻⁹ Torr).

17. Procédé selon la revendication 1, pour pulvériser une couche d'aluminium ayant une surface sensiblement plane sur une plaquette de semi-conducteur présentant des portions en relief espacées étroitement les unes des autres, sans appliquer de tension de polarisation à ladite plaquette, lequel procédé consiste à :
(a) chauffer un plateau de support de plaquette renfermant des moyens de chauffage, dans une chambre de pulvérisation, jusqu'à une température qui va de 500°C à 600°C ;
(b) insérer une plaquette de semi-conducteur, présentant des portions en relief espacées étroitement les unes des autres, dans ladite chambre de pulvérisation contenant une cible en aluminium connectée à une alimentation électrique de cible qui est capable de maintenir la tension sur ladite cible dans la gamme de -300 -600 volts en courant continu, tout au long du procédé de pulvérisation ;
(c) faire circuler une source de gaz de pulvérisation dans ladite chambre à une vitesse qui va de 15 à 300 cm³/mn, tout en maintenant ladite chambre sous une pression comprise dans la gamme de 1,3 x 10⁻⁶bar à 10,4 x 10⁻⁶bar (de 1 à 8 milliTorr) ;
(d) allumer un plasma dans ladite chambre pour pulvériser de l'aluminium depuis ladite cible jusque sur ladite plaquette, au cours d'une première étape de dépôt, pendant 0,1 à 0,3 minute, tout en maintenant un niveau d'énergie sur ladite cible suffisant pour obtenir une gamme de dépôt qui va de 20 à 30 nm (de 300 à 300 Angström) par seconde, et tout en maintenant ladite plaquette à une température inférieure à environ 150°C, en espaçant ladite plaquette dudit plateau de support chauffé ;
(e) soulever ensuite ledit plateau de support chauffé pour qu'il vienne en contact avec la face arrière de ladite plaquette ;
(f) faire circuler un gaz thermiquement conducteur vers une région fermée hermétiquement, comprise entre la surface supérieure dudit plateau de support de plaquette et la face arrière de ladite plaquette, pour coupler thermiquement ladite plaquette avec ledit plateau de support et lesdits moyens de chauffage qu'il contient, de façon à porter la température de ladite plaquette à une température comprise entre 475°C et environ 600°C ;
(g) changer la gamme de niveau d'énergie de la cible pour obtenir une vitesse de dépôt qui va de 2 à 4 nm (de 20 à 40 Angström) par seconde et pulvériser davantage d'aluminium sur la plaquette au cours d'une seconde étape de dépôt, pendant 0,7 à 1,1 minute, tout en maintenant ladite plaquette à ladite température comprise entre 475°C et environ 600°C ; et
(h) augmenter ensuite suffisamment la gamme de niveau d'énergie de la cible pour obtenir une vitesse de dépôt qui va de 10 à 25 nm (de 100 à 250 Angström) par seconde et pulvériser davantage d'aluminium sur la surface de la plaquette au cours d'une troisième étape de dépôt, tout en continuant à maintenir ladite plaquette à une température comprise entre 475°C et 500°C, jusqu'à ce qu'une épaisseur finale moyenne d'environ 1 à environ 2 µm d'aluminium ait été déposée.

18. Procédé selon la revendication 17, comprenant en outre l'étape consistant à déplacer ladite plaquette dans ladite chambre jusqu'à une position de dépôt par pulvérisation dans ladite chambre avant ladite première étape de dépôt.

19. Procédé selon la revendication 1, pour pulvériser une couche d'aluminium, ayant une surface sensiblement plane, sur une plaquette de semi-conducteur, présentant des portions en relief espacées étroitement les unes des autres, sans appliquer de tension de polarisation à ladite plaquette, lequel procédé consiste à :
(a) insérer une plaquette de semi-conducteur, présentant des portions en relief espacées étroitement les unes des autres, dans une première chambre de dépôt par pulvérisation maintenue sous une pression qui va de 1,3 x 10⁻⁶ bar à 10,4 x 10⁻⁶ bar (de 1 à 8 milliTorr) et à une température qui n'excède pas environ 100°C, ladite première chambre contenant une cible en aluminium connectée à une alimentation électrique de cible qui est capable de maintenir la tension de la cible dans la gamme qui va de -300 à -600 volts en courant continu ;
(b) allumer un plasma dans ladite chambre pour pulvériser de l'aluminium depuis ladite cible jusque sur ladite plaquette au cours d'une première étape de dépôt, pendant une période de 0,1 à 0,3 minute, tout en maintenant ladite plaquette à une temperature inférieure à environ 100°C pour déposer jusqu'à environ 200 nm (environ 2000 Angström) d'aluminium sur ladite plaquette, à une vitesse qui va de 20 à 30 nm (de 200 à 300 Angström) par seconde ;
(c) retirer ladite plaquette de ladite première chambre sous une aspiration comprise entre 1,333 x 10⁻⁸ et 1,333 x 10⁻⁹ mb (entre 10⁻⁸ et 10⁻⁹ Torr) et insérer ladite plaquette dans une seconde chambre de dépôt par pulvérisation, contenant un gaz de pulvérisation et chauffée à une température comprise entre 500°C et 600°C, tout en maintenant dans celle-ci une pression comprise dans la gamme de 1,3 x 10⁻⁶ bar à 10,4 x 10⁻⁶ bar (de 1 à 8 milliTorr), ladite seconde chambre contenant également une cible en aluminium connectée à une alimentation électrique de cible qui est capable de maintenir la tension de la cible dans la gamme de -300 à -600 volts en courant continu *;*
(d) pulvériser davantage d'aluminium sur ladite plaquette au cours d'une seconde étape de dépôt, pendant une période de temps allant de 0,7 à 1,1 minute, tout en maintenant la gamme de niveau d'énergie sur ladite cible, dans ladite seconde chambre, à un niveau suffisant pour obtenir une vitesse de dépôt qui va de 2 à environ 4 nm (de 20 à environ 40 Angström) par seconde, et tout en maintenant ladite plaquette à une température comprise entre 500°C et 600°C ; et
(e) augmenter ensuite la gamme de niveau d'énergie de la cible jusqu'à un niveau offrant une vitesse de dépôt qui va de 10 à 30 nm (de 100 à 300 Angström) par seconde, et pulvériser davantage d'aluminium jusque sur la surface de la plaquette, dans ladite seconde chambre de dépôt, au cours d'une troisième étape de dépôt, tout en continuant à maintenir ladite plaquette à une température comprise entre 500°C et 600°C.

20. Procédé selon la revendication 19, dans lequel ladite plaquette est chauffée à ladite température et maintenue à ladite température au cours desdites seconde et troisième étapes de dépôt en mettant la face arrière de ladite plaquette en contact avec un plateau de support de plaquette chauffé, renfermant un dispositif de chauffage, et en faisant circuler un gaz thermiquement conducteur vers une région fermée hermétiquement, comprise entre une surface supérieure dudit plateau de support de plaquette et ladite face arrière de ladite plaquette, pour coupler thermiquement ladite plaquette avec ledit plateau de support et ledit dispositif de chauffage qu'il contient.
